# EUROPÄISCHE PATENTSCHRIFT

(11) **EP 3 157 045 B1**
(45) Veröffentlichungstag und Bekanntmachung des Hinweises auf die Patenterteilung: **08.09.2021**
(21) Anmeldenummer: 16201978.0
(22) Anmeldetag: 26.07.2006
(51) Int. Cl.: H01L 21/306, C09G 1/02, C09K 3/14

(54) **GEGLÄTTETE III-N-SUBSTRATE**
SMOOTHED III-N SUBSTRATES
SUBSTRATS III-N POLIS

(43) Veröffentlichungstag der Anmeldung: 19.04.2017
(62) Teilanmeldung aus: 06762845.3
(73) Patentinhaber: Freiberger Compound Materials GmbH, 09599 Freiberg (DE)
(72) Erfinder: HÖLZIG, Stefan, 01187 Dresden (DE); LEIBIGER, Gunnar, 09599 Freiberg (DE)
(74) Vertreter: Prüfer & Partner mbB Patentanwälte · Rechtsanwälte

(56) Entgegenhaltungen:
- EP-A2- 1 431 426
- WO-A-2006/075527
- JP-A- 2006 060 074
- US-A1- 2002 185 054
- WEYHER J L ET AL: "Chemical polishing of bulk and epitaxial GaN", JOURNAL OF CRYSTAL GROWTH, ELSEVIER, AMSTERDAM, NL, Bd. 182, Nr. 1-2, Dezember 1997 (1997-12), Seiten 17-22, XP004100368, ISSN: 0022-0248
- MISKYS C R ET AL: "MOCVD-EPITAXY ON FREE-STANDING HVPE-GAN SUBSTRATES", PHYSICA STATUS SOLIDI (A). APPLIED RESEARCH, BERLIN, DE, Bd. 176, Nr. 1, 4. Juli 1999 (1999-07-04), Seiten 443-446, XP009049524, ISSN: 0031-8965, DOI: 10.1002/(SICI)1521-396X(199911)176:1<443:: AID-PSSA443>3.0.CO;2-Q
- H. MANK ET AL: "Polishing and characterization of thick AlN layers grown on SiC substrates by stress control hydride vapor phase epitaxy", PHYSICA STATUS SOLIDI (C), Bd. 3, Nr. 6, 10. Mai 2006 (2006-05-10), Seiten 1448-1452, XP055348018, DE ISSN: 1610-1634, DOI: 10.1002/pssc.200565151
- PU X ET AL: "Temperature dependence of Raman scattering in hexagonal indium nitride films", JOURNAL OF APPLIED PHYSICS, AMERICAN INSTITUTE OF PHYSICS, US, Bd. 98, Nr. 3, 10. August 2005 (2005-08-10), Seiten 33527-033527, XP012078239, ISSN: 0021-8979, DOI: 10.1063/1.2006208
- ROY T BLUNT: "White Light Interferometry - a production worthy technique for measuring surface roughness on semiconductor wafers", CS MANTECH CONFERENCE, APRIL 24-27, 2006, VANCOUVER, BRITISH COLUMBIA, CANADA, 1. Januar 2006 (2006-01-01), Seiten 59-62, XP055349680,

## Beschreibung

Die vorliegende Erfindung bezieht sich auf ein Verfahren zum Glätten, insbesondere zum Läppen und/oder Polieren von III-N-Oberflächen aufweisenden Materialien, insbesondere von III-N-Substraten oder von Fremdsubstrate aufweisenden III-N-Templates. Dabei bedeutet N Stickstoff und III mindestens ein Element der III. Hauptgruppe des Periodensystems, ausgewählt aus Aluminium, Gallium und Indium (im folgenden teilweise abgekürzt mit (Al, Ga, In)). Die Erfindung bezieht sich ferner auf III-N-Substrate und Fremdsubstrate aufweisende III-N-Templates. Diese III-N-Substrate und III-N-Templates sind als Substrate bzw. Templates zur Bauelementfertigung sehr gut geeignet.

Mechanisches und/oder chemisch-mechanisches Polieren ist seit längerer Zeit ein gewerblich verwendetes Standardverfahren zum Einebnen und Glätten der Oberflächen von Halbleitersubstraten, wie beispielsweise von GaAs. Dabei sind glatte und ebene sowie störungsfreie Substratoberflächen Voraussetzung für nachfolgende Epitaxie- oder Lithographieschritte zur Herstellung von mikro- oder optoelektronischen Bauelementen. Bekannte Polierverfahren für GaN-Substrate mit c-Ebenen-Orientierung unterscheiden sich auf Grund der unterschiedlichen chemischen Stabilität für die Ga-polare ([0001]-Orientierung) und die N-polare ([0001̅]-Orientierung) Oberfläche. So ist die Ga-Fläche (d.h. (0001)) bei Raumtemperatur nahezu chemisch inert, während die N-Fläche (d.h. (0001̅)) von verschiedenen Ätzmitteln (beispielsweise wässrige NaOH- oder KOH-Lösungen) angegriffen wird. Darüber hinaus ist die Ga-Fläche deutlich härter als die N-Fläche. Weyher et al. ("Chemical polishing of bulk and epitaxial GaN", J. Cryst. Growth 182 (1997) 17) stellten ein Polierverfahren für das Polieren der N-Fläche vor (Anmerkung: Eine Zuordnung der Ergebnisse zur N- bzw. Ga-Fläche erfolgte später, siehe z.B. J. Weyer et al., "Defects in GaN single crystals and homoepitaxial structures", J. Cryst. Growth 281 (2005) 135), welches aus einem mechanischen Polierschritt unter Benutzung von Diamant-Slurry und einem anschließenden CMP-Schritt unter Benutzung einer wässrigen Lösung aus KOH und/oder NaOH besteht. Für die anschließende Epitaxie ist jedoch die Ga-Fläche, für welche das angegebene Verfahren nicht anwendbar ist, von ungleich größerer Bedeutung (siehe z.B. Miskys et al., "MOCVD-Epitaxy on Free-Standing HVPE-GaN Substrates", phys. stat. sol. (a) 176 (1999) 443). Das verwendete Hartmaterial für die abrasiven Teilchen wurde von Weyher et al. nicht angegeben.

Das von Porowski et al. ("Mechano-chemical polishing of crystals and epitaxial layers of GaN and Gal-x-yAlxInyN", US 6,399,500) angegebene Verfahren entspricht dem vorstehend genannten Stand der Technik von Weyher et al.. Ein expliziter Hinweis auf die Polarität der polierten Fläche ist nicht gegeben. Das verwendete Hartmaterial für die abrasiven Teilchen wurde nicht angegeben.
Tavernier et al. ("Chemical Mechanical Polishing of Gallium Nitride", Electrochemical and Solid-State Letters 5 (2002) G61) berichten von einem CMP-Prozess unter Benutzung von Siliziumoxid als abrasives Teilchen, der ebenfalls nur für die N-Fläche von GaN erfolgreich angewandt werden konnte, für die Ga-Fläche jedoch ungeeignet ist.
Karouta et al. ("Final polishing of Ga-polar GaN substrates using reactive ion etching", Journal of Electronic Materials 28 (1999) 1448) stellten ein Verfahren zum Polieren der Ga-Fläche von GaN mittels reaktivem Ionenstrahlätzen (RIE) vor, wobei die Kristalle in einem vorangehenden mechanischen Polierschritt mit Diamantslurry vorbehandelt wurden. Das RIE-Verfahren hat zum einen den Nachteil, dass es sehr aufwendig ist und andererseits durch die Ionenbestrahlung zu einer Schädigung des Kristallgitters im oberflächennahen Bereich führt.
Kim et al. ("Method for fabricating GaN substrate", US 6,211,089) berichten von einem Verfahren zum Polieren von GaN-Substraten, bestehend aus mechanischen Polierschritten mit Diamant-Slurry und Borkarbid-Platten, wobei zum Beseitigen der Polierschäden ebenfalls ein RIE-Prozess mit den obengenannten Nachteilen sowie darüber hinaus ein thermischer Ausheilschritt verwendet wird.
Xu et al. ("High surface quality GaN wafer and method of fabricating same", US 6,951,695) beschreiben eine Methode zum chemisch-mechanischen Polieren u.a. von AlₓGa_{y}In_{z}-terminierten (0001) - AlₓGa_{y}In_{z}N-Oberflächen unter Verwendung abrasiver Siliziumoxid- oder Aluminiumoxidteilchen in saurer oder basischer Lösung. Aus der Beschreibung geht ferner hervor, dass die vorzugsweise unter Verwendung von Diamant-Slurry (oder alternativ Siliziumkarbid-, Borkarbid- oder Aluminiumoxid-Slurry) durch das mechanische Polieren, welches dem CMP-Schritt vorangestellt ist sowie durch den CMP-Prozess verursachten strukturellen Schäden im Kristall durch einen nachfolgenden nasschemischen Ätzschritt beispielsweise unter Verwendung von 180°C heißer Phosphorsäure beseitigt bzw. minimiert werden, was technologisch aufwendig ist.

Kato et al. ("Polishing composition for semiconductor substrate and method of manufacturing semiconductor substrate using same", JP-Anmeldung 2003-100373) beschreiben eine Slurryzusammensetzung hauptsächlich zum Polieren von GaN, die aus einer Mischung aus harten (z.B. Diamant) und weichen (z.B. Siliziumoxid) abrasiven Teilchen besteht. In dem beschriebenen Polierverfahren wird die Slurry auf einer Temperatur zwischen 10°C und 80°C gehalten. Das Polieren bei erhöhter Temperatur ist technologisch sehr aufwendig.

US 2002/185054 A1 (XU XUEPING [US] ET AL) 12. Dezember 2002 (2002-12-12) stellt ein Verfahren zum Polieren der Ga-Fläche von GaN vor.

Der vorliegenden Erfindung liegt die Aufgabe zugrunde, ein Verfahren zum Glätten, insbesondere zum Polieren von III-N-Oberflächen bereitzustellen, das zum einen auch auf eine chemisch nahezu inerte Fläche des III-N-Kristalls [d.h. die (Al,Ga,In)-Fläche] erfolgreich anwendbar ist und zum anderen das Kristallgitter möglichst wenig schädigt, um damit ein III-N-Substrat und ein III-N-Template mit jeweils verbesserter Oberflächenstruktur bereitstellen zu können.

Die Aufgabe wird gelöst durch ein Verfahren zum Herstellen einer geglätteten Oberfläche eines Materials, das an der zu glättenden Oberfläche eine III-N-Verbindung umfaßt, bei dem kubisches Bornitrid (cBN) als abrasives Teilchenmaterial verwendet wird. Der Glättungsprozeß kann insbesondere einen Läppprozess und/oder vor allem einen Polierprozess einer Oberfläche von III-N-Material einschließen. Es wurde überraschend gefunden, daß speziell mit dem Teilchenmaterial cBN einerseits eine Wirkung auf die chemisch nahezu inerte und harte (Al,Ga,In)-Fläche von (Al,Ga,In)N erreicht wird, andererseits aber eine Schädigung des Kristallgitters reduziert wird. Der Grund wird darin vermutet, daß kubisches Bornitrid (cBN) eine speziell zum Polieren von III-N-Material optimale Härte aufweist, mit der gegenläufige Wirkungen am besten vereinigt werden. Dieses cBN-Material ist härter als beispielsweise Siliziumoxid, so dass beim Polieren ein merklicher Abtrag auch auf der chemisch nahezu inerten und harten (Al,Ga,In)-Fläche zu erreichen ist. Andererseits ist es aber weniger hart als Diamant, was eine Schädigung des Kristallgitters reduziert.

Es sei angemerkt, daß Keizo et al. in JP-A-2001-085373 eine CMP-Polierflüssigkeit beschreiben, die als abrasives Teilchenmaterial zum Bespiel Siliziumoxid, Siliziumnitrid, Aluminium, Zirkoniumoxid, Ceroxid, Bornitrid, Diamand, harter Kohlenstoff etc. enthält, allerdings für das Polieren von Si-Wafern. Ziel der JP-A-2001-085373 ist es, abrasive Teilchen mit einem organischen oberflächenaktiven Mittel zu benetzen, um die Teilchen gut in Wasser dispergieren zu können und ein hohes Poliergeschwindigkeitsverhältnis von Siliziumoxidfilm zu Siliziumnitridfilm zu erhalten. Aus dieser Offenbarung läßt sich somit kein Hinweis auf die Lösung des speziellen Problems beim Polieren von III-N-Oberflächen entnehmen.

Das erfindungsgemäße Glätten mit kubischem Bornitrid (cBN) als abrasivem Teilchenmaterial erfolgt vorzugsweise gegenüber der III-polaren (z.B. Ga-polaren) Oberfläche [0001] des III-N-Materials, weil die erfindungsgemäße Wirkungsweise gegenüber dieser chemisch inerten Oberfläche besondere Vorteile bringt. Das erfindungsgemäße Glätten kann jedoch alternativ oder zusätzlich auch gegenüber der N-polaren Oberfläche [0001̅] des III-N-Materials durchgeführt werden.

Eine zum Polieren besonders geeignete Slurry ist eine wasserlösliche Suspension, in der zusätzlich ein oder mehrere Stoffe enthalten sind, die ausgewählt sind aus der aus Ammoniak, Kaliumhydroxid, Natriumhydroxid, Wasserstoffperoxid und organischen Basen bestehenden Gruppe.

In einer bevorzugten Ausführungsform wird ein freistehendes III-N-Substrat oder ein III-N-Template, das ein Fremdsubstrat, eine oberste III-N-Schicht und gegebenenfalls eine oder mehrere Zwischenschicht(en), die aus III-N oder aus einem anderen Material gebildet ist (sind), aufweist, geläppt und/oder poliert. Das Material des Fremdsubstrats wird vorzugsweise ausgewählt aus der aus Saphir, Siliziumkarbid, Galliumnitrid, Aluminiumnitrid, Galliumarsenid, Zinkoxid, Silizium, Lithiumaluminat und Lithiumgallat bestehenden Gruppe.

Um die Kristallqualität insbesondere an der Oberfläche weiter zu verbessern wird in einer bevorzugten Ausführungsform eine Oberfläche eines freistehenden III-N-Substrats mit einer exakt orientierten c-, a-, m- oder r-Ebene oder einer Ebene, die eine Fehlorientierung von 0.1-30° gegenüber einer c-, a-, m- oder r-Ebene aufweist, geläppt und/oder poliert. Es ist weiter von Vorteil, wenn eine Oberfläche mit einer exakt orientierten III-polaren (z.B. Ga-polaren) c-Ebene oder einer Ebene, die eine Fehlorientierung von 0.1-1° gegenüber einer exakt orientierten III-polaren (z.B. Ga-polaren) c-Ebene aufweist, geläppt und/oder poliert wird.

Geeignete mittlere Korngrößen des cBN-Teilchenmaterials liegen zum Beispiel im Bereich von 0.1 bis 20 µm, vorzugsweise im Bereich von 0.5 bis 10 µm und weiter bevorzugt im Bereich von 1 bis 6 µm.

Die Effizienz und die Wirkungen beim Polierprozeß können weiter verbessert werden, wenn der Polierprozess mehrere Schritte aufweist, insbesondere 2, 3, 4, 5 oder 6 Polierschritte, bei denen in jeweils nachfolgenden Schritten die mittlere Korngröße der kubischen Bornitridteilchen abnimmt. Eine besonders gute Kombination von Polierschritten besteht darin, dass in zwei und vorzugsweise in drei aufeinanderfolgenden Schritten die mittleren Korngrößen des cBN jeweils über 4 bis 7 µm (1. Stufe), 2 bis unter 4 µm (2. Stufe) und 0,5 bis unter 2 µm (ggf. 3. Stufe) betragen, insbesondere wenn die mittleren Korngrößen jeweils etwa 6 µm, etwa 3 µm und etwa 1 µm betragen, wobei der Ausdruck "etwa" eine Toleranz von ± 0.5 µm bedeutet.

Es ist weiter bevorzugt, vor dem Polierprozess einen Läppprozess durchzuführen. Vorteilhaft ist es, auch beim Läppprozess kubisches Bornitrid als Läppmittel zu verwenden.

Mittels Verwendung des speziell ausgewählten Glättungsmittels cBN ist es möglich, sogar bei größflächigen III-N-Substraten oder III-N-Templaten mit Durchmessern von mindestens 40mm eine einzigartige Kombination von an sich gegenläufigen Eigenschaften zu erreichen, nämlich eine ausgezeichnete Glättung mit extrem guter Homogenität der Oberflächenrauhigkeit zu kombinieren mit einer sehr gut erhaltenen Kristallqualität aufgrund einer geringfügigen, praktisch vernachlässigbaren Kristallschädigung. Ein Maß für die erfindungsgemäß erreichte Kombination von Eigenschaften ist vor allem die Homogenität der extrem geringen Oberflächenrauhigkeit über die gesamte Substrat- bzw. Waferoberfläche. So dient erfindungsgemäß der rms-Wert der Oberflächenrauhigkeit und insbesondere eine homogenen Verteilung des rms-Wertes auf der gesamten Waferoberfläche (ausgenommen eines Randausschlussbereichs von z.B. 5mm) als signifikanter Parameter, messbar beispielsweise durch ein Mapping der Waferoberfläche mit einem Weißlichtinterferometer, wobei die Standardabweichung der rms-Werte ein Maß für die Homogenität der Oberflächenrauhigkeit ist. Erfindungsgemäß werden größflächige III-N-Substrate oder III-N-Template bereitgestellt, bei denen bei einem Mapping auf der geglätteten Oberfläche mittels Weißlichtinterferometrie die Standardabweichung der rms-Werte 5% oder weniger beträgt.

Einen Vergleich zur Bedeutung der erfindungsgemäßen Homogenität der Oberflächenrauhigkeit (erfindungsgemäß angegeben durch die homogene Verteilung des rms-Wertes über die Waferoberfläche) bietet z.B. die oben erwähnte Veröffentlichung Miskys et al.. Auch nach einem aufwendigen Polierverfahren gegenüber der Ga-polaren Oberfläche der GaN-Schicht, welches 4 Polierschritte von jeweils 10 Minuten mit 15, 7, 3 und 0,25 großen Diamantpartikeln und einen weiteren langen Polierschritt mit besonders feinem Poliermaterial (0,04 µm groß) einschloß, blieben gemäß Stand der Technik bei ansonsten relativ glatter Oberfläche mikroskopische Kratzer an der polierten Oberfläche übrig, die dann als vorrangige Nukleationsstellen des GaN-Wachstums wirkten und nach dem epitaxialen Wachstum über diesen Kratzstellen deutlich feststellbare Oberflächendefekte erzeugten.

Als Maß für die gleichzeitig ausgezeichnete Kristallqualität sind insbesondere Messungen aus Rockingkurvenmapping und/oder durch Mikro-Ramanmapping geeignet. So beträgt bei dem freistehenden III-N-Substrat und bei dem III-N-Template gemäß der Erfindung bei einem Rockingkurvenmapping auf der durch den erfindungsgemäßen Glättungsprozeß erhaltenen Oberfläche parallel zur Wachstumsebene die Standardabweichung der gemessenen Halbwertsbreiten 5% oder weniger, vorzugsweise 3% oder weniger und weiter bevorzugt 2% oder weniger. Alternativ oder gleichzeitig beträgt bei dem freistehenden III-N-Substrat und dem III-N-Template gemäß der Erfindung bei einem Mikro-Ramanmapping auf der durch den erfindungsgemäßen Glättungsprozeß erhaltenen Oberfläche parallel zur Wachstumsebene die Standardabweichung der gemessenen Halbwertsbreiten des E₂-Phonons 5% oder weniger, bevorzugt 3% oder weniger und weiter bevorzugt 2% oder weniger.

Die Standardabweichung kann ermittelt werden, indem bei einer Vielzahl, z.B. bei 100 Messpunkten der zu messenden Oberfläche jeweils Rockingkurvmappingmessungen oder Mikro-Ramanmessungen durchgeführt werden, von allen Messungen der Mittelwert der Halbwertsbreiten gebildet wird und gegenüber diesem Mittelwert über eine übliche statistische Auswertung die Standardabweichung ermittelt wird.

Vorteilhaft können erfindungsgemäß III-N-Substrate oder III-N-Template mit Durchmessern von mindestens 2 Zoll (ca. 5 cm), mindestens 3 Zoll (ca. 7,6 cm) oder mindestens 4 Zoll (ca. 10 cm) oder mehr hergestellt werden.

Entsprechend der bevorzugten Anwendung des erfindungsgemäßen Glättungsprozesses gegenüber der III-polaren (z.B. Ga-polaren) Oberfläche werden erfindungsgemäß bevorzugt III-N-Substrate oder III-N-Template bereitgestellt, bei denen die oben beschriebenen Parameter in Bezug auf Weißlichtinterferometer-Mapping, Rockingkurvenmappings und/oder Mikro-Ramanmappings bezüglich der III-polaren (z.B. Ga-polaren) Oberfläche gelten. Weiter bevorzugt gelten die genannten Parameter jedoch auf beiden Oberflächen, also sowohl auf der III- (z.B. Ga-) als auch auf der N-polaren Oberfläche.

In den obigen Definitionen bedeutet N Stickstoff und III mindestens ein Element der Gruppe III des Periodensystems der Elemente. Das III-Element sollte aus der Gruppe von Elementen, die aus Al, Ga und In besteht, allein oder in Kombination ausgewählt sein. Eine entsprechende allgemeine Formel lautet daher AlₓGa_{y}In_{z}N worin 0≤x≤1, 0≤y≤1, 0≤z≤1 und x+y+z=1. Beispiele für mögliche III-N-Verbindungen sind quaternäre Verbindungen wie (Al,Ga,In)N, ternäre Verbindungen wie (Al,Ga)N, (Ga,In)N und (Al,In)N, oder binäre Verbindungen wie GaN oder AlN. Unter den ausgewählten Elementen der III. Gruppe, wie beispielhaft in den vorstehenden Klammern angegeben, sind alle denkbaren Atomverhältnisse untereinander möglich, d.h. von 0 bis 100 Atom-% für das jeweilige Element (z.B. (Al,Ga)N = AlₓGa₁₋ₓN, wobei 0 ≤ x ≤ 1). (Al,Ga)N und GaN sind besonders bevorzugt. Die nachfolgende Beschreibung eines Beispiels ist nicht nur auf das dort angegebene III-N-Verbindungsbeispiel, sondern auf alle möglichen III-N-Verbindungen anwendbar. Neben den III-N-Substraten ist die Erfindung günstig auch auf ein III-N-Template anwendbar, das ein oben erwähntes Fremdsubstrat, eine oberste III-N-Schicht und gegebenenfalls eine oder mehrere Zwischenschicht(en), die aus III-N oder aus einem anderen Material gebildet ist (sind), aufweist und dessen III-N-Oberfläche entsprechend geglättet ist. Die Zusammensetzungen von III-N für dünne und für dicke Schichten, Substrate und Templates können unabhängig gewählt werden. Die Zusammensetzungen können gleich oder verschieden sein. Die Erfindung ist besonders geeignet anwendbar auf III-N-Schichten, -Substrate und -Templates, die mittels Epitaxie-Verfahren hergestellt wurden, bevorzugt mittels Gasphasenepitaxie wie mittels MOVPE und vor allem mittels HVPE. Das III-N-Verbindungsmaterial ist vorteilhafterweise kristallin und vor allem einkristallin.

### Beschreibung von bevorzugten Ausführungsformen und Beispielen

Die Erfindung wird nachfolgend anhand von bevorzugten Ausführungsformen und Beispielen, die jedoch nur zur Veranschaulichung und nicht einschränkend zu verstehen sind, unter Bezugnahme auf die beigefügte Zeichnung näher beschrieben, wobei
Fig. 1 einen Vergleich der Oberflächenrauhigkeit (rms-Wert) eines GaN-Wafers zeigt nach einem mechanischen Polieren mit cBN-haltigem Slurry (Erfindung) und mit Diamanthaltigem Slurry (Vergleich), und
Fig. 2 ein Prinzip für eine Oberflächenuntersuchung zeigt, die zur Messung von rms-Werten mittels Weißlichtinterferometrie geeignet ist.

Der Poliervorgang kann auf einer handelsüblichen Poliermaschine stattfinden, wobei während des Polierens in einer möglichen Ausführungsform die Trägerplatte und der/die darauf befestigte(n) Wafer rotieren sowie zusätzlich der/die Wafer eine oszillatorische Bewegung in radialer Richtung ausführt/ausführen. Polierteller mit dem darauf befestigten Poliertuch und Wafer werden während des Polierens aneinandergedrückt, wobei die Slurry auf das Poliertuch zugetropft wird.
Die Slurry ist eine Dispersion auf wässriger Basis mit cBN als abrasivem Teilchen. Um optimal glatte Oberflächen zu erhalten, werden mehrere Polierschritte durchgeführt, wobei die mittlere Korngröße von cBN bei jedem nachfolgenden Polierschritt abnimmt. Eine mögliche Abstufung sind beispielsweise mittlere Korngrößen von 6µm, 3µm und 1µm in drei aufeinanderfolgenden Polierschritten.
Das Poliertuch kann optional während bzw. alternativ vor und zwischen den Polierfahrten konditioniert werden (beispielsweise mit ,DiaGrid' Pad conditioner von Rohm and Haas, Feldkirchen, Germany).
Die zu polierenden (Al,Ga,In)N-Wafer oder -Templates können durch verschiedene bekannte Gasphasen- oder Lösungszüchtungsmethoden hergestellt werden. Direkt nach dem Wachstumsschritt können weitere mechanische Bearbeitungsschritte (einer oder mehrere) ausgewählt aus den nachfolgend genannten Schritten dem Polierprozess vorangestellt sein:
- Rundschleifen,
- Schleifen von Flats und/oder Notches
- Drahtsägen,
- Kantenverrunden,
- Läppen,
wobei der letztgenannte Läppschritt aus mehreren aufeinanderfolgenden Teilschritten mit abnehmender mittlerer Körnung des Läppmittels bestehen kann. Als Läppmittel kann beispielsweise Siliziumkarbid, Diamant oder kubisches Bornitrid verwendet werden.

Zum Mapping der Waferoberfläche mit einem Weißlichtinterferometer, wobei die Standardabweichung der rms-Werte als Maß für die Homogenität der Oberflächenrauhigkeit dienen kann, kann beispielsweise die Waferoberfläche in ein Raster mit jeweils maximal 5 mm Abstand in zwei zueinander orthogonalen Richtungen eingeteilt werden. Unter Beachtung eines Randausschlussbereichs von 5 mm kann nun in jedem Raster ein Oberflächenscan durchgeführt werden, wobei der Scanbereich wenigstens 1% der Rastergröße betragen sollte. Die rms-Werte können standardmäßig mit einem kommerziell erhältlichen Weißlichtinterferometer unter Verwendung von Weißlicht gemessen werden.

Die Kristallqualität der behandelten Oberfläche lässt sich messtechnisch erfassen beispielsweise mittels Röntgenbeugung z.B. als räumliche Verteilung der Absolutlagen und/oder Halbwertsbreiten von Röntgenbeugungskurven entsprechend der Beugung an bestimmten Netzebenenscharen. Die Homogenität der Kristallqualität in der Wachstumsebene kann man beispielsweise an Hand eines sogenannten RockingkurvenMappings (Aufnehmen von ω-Scans an verschiedenen Probenstellen der Oberfläche), welches in einer Ebene parallel zur Wachstumsebene aufgenommen wurde, festmachen. Im Falle eines in [0001]-Richtung gewachsenen Kristalls kann man bei den ω-Scans z.B. die Reflexion der (0002)-Netzebenen nutzen. Die Homogenität der Kristallqualität in Wachstumsrichtung kann an Hand der Standardabweichung der Mittelwerte der Halbwertsbreiten der (0002) ω-Scans der einzelnen Substrate, die aus dem entsprechenden Bulkkristall gewonnen wurden, bestimmt werden.

Eine zweite Methode zur Bestimmung der Homogenität der Kristallqualität sind Mikro-Ramanmappings. So sind beispielsweise die Standardabweichungen von Frequenz und Halbwertsbreite des E₂-Phonons bei einem Scan auf der Oberfläche parallel zur Wachstumsebene ein Maß für die Homogenität der Kristallqualität parallel zur Wachstumsebene.

Die Mikro-Ramanmessungen können mit einer Laseranregungswellenlänge von 532 nm (Frequenzverdoppelter Nd:YAG-Laser), einer Anregungsleistung von 3 mW (z.B. mit einem Labram800HR Spektrometer von Jobin Yvon) durchgeführt werden, wobei die Laserlinie mit Hilfe einer Mikroskopoptik auf einen Strahldurchmesser von ∼ 1µm auf der Probe fokussiert werden kann. Bei dem Scan auf der Oberfläche beträgt die Schrittweite in x- und y-Richtung zum Beispiel ∼2,5mm. Es wird ein passender Randausschlussbereich gewählt, zum Beispiel 2mm vom Waferrand. Bei dem Scan auf der senkrecht zur Oberfläche liegenden Spaltfläche des Wafers beträgt die Schrittweite in z-Richtung ∼10µm. Frequenz und Halbwertsbreite des E₂-Phonons werden durch Lorentz-Linienformanalysen bestimmt.

### Ausführungsbeispiel:

Als Poliermaschine kam eine PT 350 Premium der Fa. I-B-S Fertigungs- und Vertriebs-GmbH zum Einsatz. GaN-Wafer mit (0001)-Orientierung wurden mit der N-polaren Rückseite mittels Thermowax auf eine erhitzte Trägerplatte aufgeklebt, wobei Letztere bis zum Prozessbeginn wieder auf Raumtemperatur abgekühlt war. Das Poliertuch, ein mittelhartes Tuch auf Polyurethanbasis (Rohm and Haas SUBA IV), wurde auf den Polierteller aufgeklebt. Die cBN-Slurry (CBN Slurry W69S1 6µm/3µmHVY, Handelsagentur Manfred Böduel, Wittenberg, Germany) wurde mit einer Flussrate von ∼5 ml/min zugetropft. Die Anwendung der cBN-Slurry erfolgte in zwei unabhängig voneinander ablaufenden Polierstufen mit der Verwendung von jeweils 6µm bzw. 3µm großen cBN-Partikeln (jeweils mittlere Partikelgröße). Polierteller und Probe rotierten mit ∼30 min⁻¹ bzw. ∼20 min⁻¹. Darüberhinaus oszillierte die azentrisch befestigte Probe in radialer Richtung. Der Polierdruck lag bei ∼1700 g/cm².
Die Ga-polaren Oberflächen derart polierter Wafer wurden mittels eines kommerziellen Weißlichtinterferometers (Zygo New View) mit den Ga-polaren Oberflächen von Wafern verglichen, die unter sonst gleichen Bedingungen mit einer Diamant-Slurry (mittlere Korngrößen 6 µm und 3 µm) poliert wurden. Die Meßdurchführung ist unten näher beschrieben.

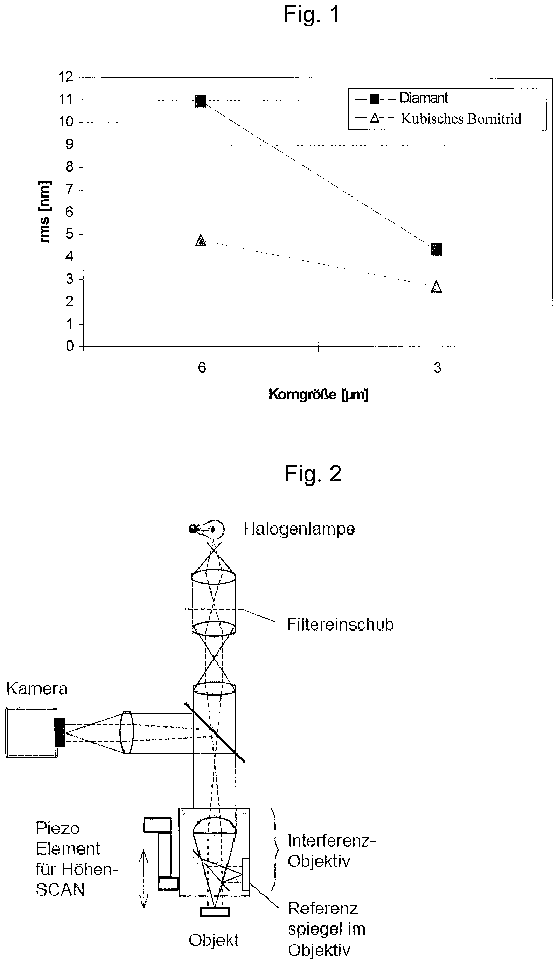

Fig. 1 zeigt einen Vergleich der mittleren Oberflächenrauhigkeit (rms-Wert) nach der mechanischen Politur mit cBN- und Diamant-Slurry.

Wie Fig. 1 zu entnehmen ist, erreicht man nach beiden Polierstufen mit der cBN-Slurry deutlich niedrigere Oberflächenrauhigkeiten und vor allem eine geringere Standardabweichung der absoluten rms-Werte gegenüber dem Mittelwert im Vergleich zur Diamant-Slurry. Dabei wurden die rms-Werte auf einer Fläche von 350 x 260 µm² gemessen.

Analyse der GaN-Oberflächen, speziell zur Rauhigkeitsmessung mit Standardmessung von rms-Werten mittels kommerziellem Weißlichtinterferometer (Zygo New View).
Ein Prinzip eines Weißlichtinterferometers ist in Fig. 2 gezeigt (Quelle: zygoLOT).
Das Messprinzip beruht auf der Kombination eines Mikroskops mit einem Interferometer. Hierbei wird das Licht einer Weißlichtquelle in zwei Strahlengänge unterteilt, wobei ein Teilstrahl an einem Referenzspiegel und der andere an der Probe reflektiert wird. Anschließend werden beide zur Überlagerung gebracht. Durch die Topographie der Probenoberfläche kommt es zu unterschiedlichen optischen Weglängen beider Strahlen und damit zu einem Interferenzmuster, dessen Auswertung mittels Frequenz Domänen Analyse (FDA) erfolgt. Die Verwendung von Weißlicht gestattet die Auswertung der Interferenzen mehrerer Lichtwellenlängen. Die relative Position zwischen Referenzspiegel und Probenoberfläche kann mittels Piezoaktor verfahren werden.

Aus der Korrelation der hochgenau bekannten Wegänderung zwischen Spiegel und Probe mit der Auswertung des Interferenzsignals werden vertikale Genauigkeiten bis 0,1 nm erzielt. Eine Probenreflektivität von 0,4 % ist für die Messung ausreichend, so dass auch gering reflektierende Oberflächen gemessen werden können.

Mikro-Ramanmessungen zur Bestimmung Frequenz und Halbwertsbreite des E₂-Phonons können mit einem kommerziellen Labram800HR Spektrometer von Jobin Yvon wie folgt durchgeführt werden:
- Laseranregungswellenlänge 532 nm (Frequenzverdoppelter Nd:YAG-Laser),
- Anregungsleistung 3 mW
- Fokussierung der Laserlinie mit Hilfe einer Mikroskopoptik auf einen Strahldurchmesser von ∼ 1µm auf die Probe
Das Spektrometer wird zusätzlich mit Hilfe von Ne-Plasmalinien kalibriert. Die Messungen werden in Rückstreugeometrie durchgeführt, wobei die Polarisatorstellungen derart gewählt werden, daß die E₂-Phonon detektiert werden können [Scan auf Oberfläche: z(y x/y)-z; Scan auf Spaltfläche: y(x x)-y]. Bei dem Scan auf der Oberfläche beträgt die Schrittweite in x- und y-Richtung ∼2,5mm. Der Randausschlussbereich beträgt 2mm vom Waferrand. Bei dem Scan auf der senkrecht zur Oberfläche liegenden Spaltfläche des Wafers beträgt die Schrittweite in z-Richtung ∼10µm. Frequenz und Halbwertsbreite des E₂-Phonons werden durch Lorentz-Linienformanalysen bestimmt.

## Patentansprüche

1. Freistehendes III-N-Substrat, wobei III mindestens ein Element der Gruppe III des Periodensystems ausgewählt aus Al, Ga und In bedeutet; mit einem Durchmesser größer als 40 mm, wobei (i) bei einem Mapping auf der Oberfläche mittels Weißlichtinterferometrie die Standardabweichung der rms-Werte 5% oder weniger beträgt, und wobei ferner:
(ii) bei einem Rockingkurvenmapping auf der Oberfläche parallel zur Wachstumsebene die Standardabweichung der gemessenen Halbwertsbreiten 5% oder weniger beträgt, und/oder
(iii) bei einem Mikro-Ramanmapping auf der Oberfläche parallel zur Wachstumsebene die Standardabweichung der gemessenen Halbwertsbreiten des E₂-Phonons 5% oder weniger beträgt;
wobei die genannten Mappings mit folgenden Bedingungen messbar sind:
ad (i) - Mapping der Waferoberfläche mit einem Weißlichtinterferometer: nachdem die Waferoberfläche in ein Raster mit jeweils maximal 5 mm Abstand in zwei zueinander orthogonalen Richtungen eingeteilt wird, wird unter Beachtung eines Randausschlussbereichs von 5 mm in jedem Raster ein Oberflächenscan durchgeführt, wobei der Scanbereich wenigstens 1% der Rastergröße beträgt und die rms-Werte mit einem Weißlichtinterferometer unter Verwendung von Weißlicht gemessen werden;
ad (ii) - Rockingkurven-Mapping: es werden Röntgenbeugungskurven entsprechend der Beugung an bestimmten Netzebenenscharen erstellt, wobei ω-Scans an verschiedenen Probenstellen der Oberfläche in einer Ebene parallel zur Wachstumsebene aufgenommen werden, wonach die Standardabweichung der Mittelwerte der Halbwertsbreiten der aufgenommenen ω-Scans bestimmt werden;
ad (iii) - Mikro-Ramanmessungen zur Bestimmung der Halbwertsbreite des E₂:
- Laseranregungswellenlänge 532 nm (Frequenzverdoppelter Nd:YAG-Laser),
- Anregungsleistung 3 mW
- Fokussierung der Laserlinie mit Hilfe einer Mikroskopoptik auf einen Strahldurchmesser von ∼ 1µm auf die Probe,
wobei das Spektrometer mit Hilfe von Ne-Plasmalinien kalibriert wird, die Messung in Rückstreugeometrie durchgeführt wird, beim Scan auf der Oberfläche in x- und y-Richtung die Schrittweite ∼2,5mm beträgt und der Randausschlussbereich 2mm vom Waferrand beträgt und beim Scan auf der senkrecht zur Oberfläche liegenden Spaltfläche des Wafers die Schrittweite in z-Richtung ∼10µm beträgt, und wobei die Halbwertsbreite des E₂-Phonons durch Lorentz-Linienformanalysen bestimmt wird.

2. Freistehendes III-N-Substrat gemäß Anspruch 1, wobei Oberfläche des III-N-Materials poliert wurde mit Hilfe eines abrasive Teilchen umfassenden Glättungsmittels in Form einer Slurry-Dispersion auf wässriger Basis, wobei das Material der verwendeten abrasiven Teilchen der Slurry kubisches Bornitrid ist und der Polierprozeß mehrere Schritte einschloss, bei denen in jeweils nachfolgenden Schritten die mittlere Korngröße der kubischen Bomitridteilchen abnimmt.

3. Freistehendes III-N-Substrat gemäß Anspruch 1 oder 2, wobei die Oberfläche des freistehenden III-N-Substrats eine exakt orientierte c-, a- ,m- oder r-Ebene oder eine Ebene, die eine Fehlorientierung von 0.1-30° gegenüber einer c-, a- ,m- oder r-Ebene aufweist, darstellt, vorzugsweise eine Oberfläche mit einer exakt orientierten III-polaren c-Ebene oder eine Ebene, die eine Fehlorientierung von 0.1-1° gegenüber einer exakt orientierten III-polaren c-Ebene aufweist, darstellt.

4. Freistehendes III-N-Substrat gemäß Anspruch 2 oder 3, wobei die im Polierprozess in drei aufeinanderfolgenden Schritten verwendeten abrasiven Teilchen des kubischen Bornitrids eine mittlere Korngröße von jeweils über 4 bis 7 µm, 2 bis unter 4 µm und 0,5 bis unter 2 µm aufwiesen, vorzugsweise eine mittlere Korngröße von jeweils etwa 6 µm, etwa 3 µm und etwa 1 µm aufwiesen.

5. Freistehendes III-N-Substrat gemäß einem der Ansprüche 2 bis 4, wobei vor dem Polierprozess ein Läppprozess durchgeführt wurde, wobei als Läppmittel kubisches Bornitrid verwendet wurde.

6. Freistehendes III-N-Substrat gemäß einem der Ansprüche 2 bis 5, wobei der Polierprozess mit kubischem Bornitrid als Glättungsmittel auf die III-polare Oberfläche [0001] des III-N-Materials angewendet wurde.

7. III-N-Templat, wobei III mindestens ein Element der Gruppe III des Periodensystems ausgewählt aus Al, Ga und In bedeutet;
wobei das Templat ein Fremdsubstrat, eine oberste III-N-Schicht und gegebenenfalls eine oder mehrere Zwischenschicht(en), die aus III-N oder aus einem anderen Material gebildet ist (sind), aufweist, wobei das III-N-Templat einen Durchmesser von größer als 40 mm besitzt und (i) bei einem Mapping auf der Oberfläche mittels Weißlichtinterferometrie die Standardabweichung der rms-Werte 5% oder weniger beträgt, und ferner:
(ii) bei einem Rockingkurvenmapping auf der Oberfläche parallel zur Wachstumsebene die Standardabweichung der gemessenen Halbwertsbreiten 5% oder weniger beträgt; und/oder
(iii) bei einem Mikro-Ramanmapping auf der Oberfläche parallel zur Wachstumsebene die Standardabweichung der gemessenen Halbwertsbreiten des E₂-Phonons 5% oder weniger beträgt;
wobei die genannten Mappings mit folgenden Bedingungen messbar sind:
ad (i) - Mapping der Waferoberfläche mit einem Weißlichtinterferometer: nachdem die Waferoberfläche in ein Raster mit jeweils maximal 5 mm Abstand in zwei zueinander orthogonalen Richtungen eingeteilt wird, wird unter Beachtung eines Randausschlussbereichs von 5 mm in jedem Raster ein Oberflächenscan durchgeführt, wobei der Scanbereich wenigstens 1% der Rastergröße beträgt und die rms-Werte mit einem Weißlichtinterferometer unter Verwendung von Weißlicht gemessen werden;
ad (ii) - Rockingkurven-Mapping: es werden Röntgenbeugungskurven entsprechend der Beugung an bestimmten Netzebenenscharen erstellt, wobei ω-Scans an verschiedenen Probenstellen der Oberfläche in einer Ebene parallel zur Wachstumsebene aufgenommen werden, wonach die Standardabweichung der Mittelwerte der Halbwertsbreiten der aufgenommenen ω-Scans bestimmt werden;
ad (iii) - Mikro-Ramanmessungen zur Bestimmung der Halbwertsbreite des E₂:
- Laseranregungswellenlänge 532 nm (Frequenzverdoppelter Nd:YAG-Laser),
- Anregungsleistung 3 mW
- Fokussierung der Laserlinie mit Hilfe einer Mikroskopoptik auf einen Strahldurchmesser von ∼ 1µm auf die Probe,
wobei das Spektrometer mit Hilfe von Ne-Plasmalinien kalibriert wird, die Messung in Rückstreugeometrie durchgeführt wird, beim Scan auf der Oberfläche in x- und y-Richtung die Schrittweite ∼2,5mm beträgt und der Randausschlussbereich 2mm vom Waferrand beträgt und beim Scan auf der senkrecht zur Oberfläche liegenden Spaltfläche des Wafers die Schrittweite in z-Richtung ∼10µm beträgt, und wobei die Halbwertsbreite des E₂-Phonons durch Lorentz-Linienformanalysen bestimmt wird.

8. III-N-Templat gemäß Anspruch 7, wobei die Oberfläche des III-N-Materials poliert wurde mit Hilfe eines abrasive Teilchen umfassenden Glättungsmittels in Form einer Slurry-Dispersion auf wässriger Basis, wobei das Material der verwendeten abrasiven Teilchen der Slurry kubisches Bornitrid ist und der Polierprozeß mehrere Schritte einschloss, bei denen in jeweils nachfolgenden Schritten die mittlere Korngröße der kubischen Bomitridteilchen abnimmt.

9. III-N-Templat gemäß Anspruch 7 oder 8, wobei die Oberfläche des freistehenden III-N-Substrats eine exakt orientierte c-, a- ,m- oder r-Ebene oder eine Ebene, die eine Fehlorientierung von 0.1-30° gegenüber einer c-, a- ,m- oder r-Ebene aufweist, darstellt, vorzugsweise eine Oberfläche mit einer exakt orientierten III-polaren c-Ebene oder eine Ebene, die eine Fehlorientierung von 0.1-1° gegenüber einer exakt orientierten III-polaren c-Ebene aufweist, darstellt.

10. III-N-Templat gemäß Anspruch 8 oder 9, wobei die im Polierprozess in drei aufeinanderfolgenden Schritten verwendeten abrasiven Teilchen des kubischen Bornitrids eine mittlere Korngröße von jeweils über 4 bis 7 µm, 2 bis unter 4 µm und 0,5 bis unter 2 µm aufwiesen, vorzugsweise eine mittlere Korngröße von jeweils etwa 6 µm, etwa 3 µm und etwa 1 µm aufwiesen.

11. III-N-Templat gemäß einem der Ansprüche 8 bis 10, wobei vor dem Polierprozess ein Läppprozess durchgeführt wurde, wobei als Läppmittel kubisches Bornitrid verwendet wurde.

12. III-N-Templat gemäß einem der Ansprüche 8 bis 11, wobei der Polierprozess mit kubischem Bornitrid als Glättungsmittel auf die III-polare Oberfläche [0001] des III-N-Materials angewendet wurde.

13. III-N-Templat gemäß einem der Ansprüche 7 bis 12, wobei das Material des Fremdsubstrats ausgewählt ist aus der aus Saphir, Siliziumkarbid, Galliumnitrid, Aluminiumnitrid, Galliumarsenid, Zinkoxid, Silizium, Lithiumaluminat und Lithiumgallat bestehenden Gruppe.

14. Verwendung des III-N-Substrats gemäß einem der Ansprüche 1 bis 6 oder des III-N-Templates gemäß einem der Ansprüche 7 bis 13 zur Herstellung eines optischen, elektronischen oder optoelektronischen Bauelements.

## Claims

1. Free-standing III-N substrate, wherein III means at least one element of group III of the periodic table selected from Al, Ga and In, having a diameter greater than 40 mm and having the following properties:
(i) when mapping on the surface by white light interferometry, the standard deviation of the rms values is 5% or less, and
(ii) for a Rocking curve mapping on the surface parallel to the growth plane, the standard deviation of the measured half-widths is 5% or less ; and/or
(iii) for a micro-Raman mapping on the surface parallel to the growth plane, the standard deviation of the measured half-widths of the E₂ phonon is 5% or less ;
wherein said mappings are measurable with the following conditions:
ad (i) - Mapping of the wafer surface with a white light interferometer: after dividing the wafer surface into a grid, each with a maximum spacing of 5 mm in two mutually orthogonal directions, a surface scan is carried out, considering an edge exclusion range of 5 mm in each grid, the scan range being at least 1% of the grid size, and the rms values are measured with a white light interferometer using white light;
ad (ii) - Rocking curve mapping: X-ray diffraction curves corresponding to diffraction at specific mesh plane arrays are generated, where ω-scans are acquired at different sample locations of the surface in a plane parallel to the growth plane, after which the standard deviation of the mean values of the half-widths of the acquired ω-scans are determined;
ad (iii) - micro-Raman measurements to determine the half-width of the E₂:
- Laser excitation wavelength 532nm (frequency doubled Nd:YAG laser)
- Excitation power 3 mW
- Focusing the laser line to a beam diameter of ∼ 1µm on the sample with microscope optics,
wherein the spectrometer is calibrated using Ne plasma lines, the measurement is performed in backscatter geometry, when scanning on the surface in the x and y directions the step size is ∼2.5 mm and the edge exclusion region is 2 mm from the wafer edge and when scanning on the slit face of the wafer perpendicular to the surface the step size in the z direction is ∼10µm, and wherein the half width of the E2 phonon is determined by Lorentz line shape analyses.

2. Free-standing III-N substrate according to claim 1, wherein the surface of the III-N material has been polished by means of a smoothing agent comprising abrasive particles in the form of an aqueous-based slurry dispersion, wherein the material of the abrasive particles of the slurry used is cubic boron nitride and the polishing process included a plurality of steps in each of which the average grain size of the cubic boron nitride particles decreases in subsequent steps.

3. Free-standing III-N substrate according to claim 1 or 2, wherein the surface of the free-standing IIIN substrate is an exactly oriented c-, a- ,m- or r-plane or a plane having a misorientation of 0.1-30° with respect to a c-, a- ,m- or r-plane, preferably a surface having an exactly oriented III-polar c-plane or a plane having a misorientation of 0.1-1° with respect to an exactly oriented III-polar c-plane.

4. Free-standing III-N substrate according to claim 2 or 3, wherein the abrasive particles of cubic boron nitride used in the polishing process in three successive steps had an average grain size of over 4 to 7 µm, 2 to below 4 µm and 0.5 to below 2 µm, respectively, preferably having an average grain size of about 6 µm, about 3 µm and about 1 µm, respectively.

5. Free-standing III-N substrate according to any one of claims 2 to 4, wherein a lapping process was carried out prior to the polishing process, wherein cubic boron nitride was used as the lapping agent.

6. Free-standing III-N substrate according to any one of claims 2 to 5, wherein the polishing process using cubic boron nitride as a smoothing agent has been- applied to the III-polar surface [0001] of the III-N material.

7. III-N template, wherein III is at least one element of Group III of the Periodic Table selected from Al, Ga and In, the template comprising a foreign substrate, an uppermost III-N layer and optionally one or more intermediate layer(s) formed of III-N or of another material, the III-N template having a diameter greater than 40 mm and having the following properties:
(i) when mapping on the surface by white light interferometry, the standard deviation of the rms values is 5% or less, and
(ii) for a Rocking curve mapping on the surface parallel to the growth plane, the standard deviation of the measured half-widths is 5% or less; and/or
(iii) for a micro-Raman mapping on the surface parallel to the growth plane, the standard deviation of the measured half-widths of the E₂ phonon is 5% or less ;
wherein said mappings are measurable with the following conditions:
ad (i) - Mapping of the wafer surface with a white light interferometer: after dividing the wafer surface into a grid, each with a maximum spacing of 5 mm in two mutually orthogonal directions, a surface scan is carried out, considering an edge exclusion range of 5 mm in each grid, the scan range being at least 1% of the grid size, and the rms values are measured with a white light interferometer using white light;
ad (ii) - Rocking curve mapping: X-ray diffraction curves corresponding to diffraction at specific mesh plane arrays are generated, where ω-scans are acquired at different sample locations of the surface in a plane parallel to the growth plane, after which the standard deviation of the mean values of the half-widths of the acquired ω-scans are determined;
ad (iii) - micro-Raman measurements to determine the half-width of the E₂:
- Laser excitation wavelength 532nm (frequency doubled Nd:YAG laser)
- Excitation power 3 mW
- Focusing the laser line to a beam diameter of ∼ 1µm on the sample with microscope optics,
wherein the spectrometer is calibrated using Ne plasma lines, the measurement is performed in backscatter geometry, when scanning on the surface in the x and y directions the step size is ∼2.5mm and the edge exclusion region is 2mm from the wafer edge and when scanning on the slit face of the wafer perpendicular to the surface the step size in the z direction is ∼10µm, and wherein the half width of the E₂ phonon is determined by Lorentz line shape analyses.

8. III-N template according to claim 7, wherein the surface of the III-N material has been polished by means of a smoothing agent comprising abrasive particles in the form of an aqueous-based slurry dispersion, wherein the material of the abrasive particles of the slurry used is cubic boron nitride and the polishing process included a plurality of steps in each of which the average grain size of the cubic boron nitride particles decreases in subsequent steps.

9. III-N template according to claim 7 or 8, wherein the surface of the free-standing IIIN substrate -is an exactly oriented c-, a- ,m- or r-plane or a plane having a misorientation of 0.1-30° with respect to a c-, a- ,m- or r-plane, preferably a surface having an exactly oriented III-polar c-plane or a plane having a misorientation of 0.1-1° with respect to an exactly oriented III-polar c-plane.

10. III-N template according to claim 8 or 9, wherein the abrasive particles of cubic boron nitride used in the polishing process in three successive steps had an average grain size of respectively above 4 to 7 µm, 2 to below 4 µm and 0.5 to below 2 µm, preferably having an average grain size of respectively about 6 µm, about 3 µm and about 1 µm.

11. III-N templated article according to any one of claims 8 to 10, wherein a lapping process was performed prior to the polishing process, wherein cubic boron nitride was used as the lapping agent.

12. III-N template according to any one of claims 8 to 11, wherein the polishing process with cubic boron nitride as smoothing agent has -been applied to the III-polar surface [0001] of the III-N material.

13. III-N template according to any one of claims 7 to 12, wherein the material of the foreign substrate is selected from the group consisting of sapphire, silicon carbide, gallium nitride, aluminium nitride, gallium arsenide, zinc oxide, silicon, lithium aluminate and lithium gallate.

14. Use of the III-N substrate according to any one of claims 1 to 6 or the III-N template according to any one of claims 7 to 13 for the manufacture of an optical, electronic or optoelectronic device.

## Revendications

1. Substrat de III-N dégagé, dans lequel III représente au moins un élément du groupe III du système périodique choisi parmi Al, Ga et In ; ayant un diamètre supérieur à 40 mm, dans lequel (i) lors d'une cartographie sur la surface par interférométrie à lumière blanche, l'écart-type des valeurs RMS est de 5 % ou moins, et dans lequel, en outre :
(ii) lors d'une cartographie par courbe d'oscillation sur la surface parallèle au plan de croissance, l'écart-type des demi-largeurs mesurées est de 5 % ou moins, et/ou
(iii) lors d'une cartographie par micro-spectrométrie Raman sur la surface parallèle au plan de croissance, l'écart-type des demi-largeurs mesurées du phonon E₂ est de 5 % ou moins ;
dans lequel les cartographies citées peuvent être mesurées dans les conditions suivantes :
ad (i) - cartographie de la surface de la tranche avec un interféromètre à lumière blanche : après avoir divisé la surface de la tranche en un maillage de 5 mm d'intervalle respectivement au maximum dans deux directions orthogonales l'une à l'autre, un balayage de la surface est réalisé en respectant une zone d'exclusion de bordure de 5 mm dans chaque maillage, la zone de balayage étant au moins de 1 % de la taille du maillage et les valeurs RMS étant mesurée par un interféromètre à lumière blanche en utilisant de la lumière blanche ;
ad (ii) - cartographie par courbe d'oscillation : des courbes de diffraction aux rayons X sont établies conformément à la diffraction sur des ciseaux de plan de réseau déterminés, les balayages ω étant enregistrés à différents endroits de test de la surface dans un plan parallèle au plan de croissance, après quoi l'écart-type des moyennes des demi-largeurs des balayages ω enregistrés est déterminé ;
ad (iii) - mesures par micro-spectrométrie de Raman pour déterminer la demi-largeur de E₂ :
- longueur d'onde d'excitation du laser de 532 nm (Laser Nd:YAG doublé en fréquence),
- puissance d'excitation de 3 mW
- focalisation de la ligne laser à l'aide d'une optique de microscope sur un diamètre de faisceau de ∼1 µm sur l'échantillon,
le spectromètre étant calibré à l'aide de lignes de plasma Ne, la mesure étant réalisée en géométrie de rétrodiffusion, la largeur de pas étant de ∼2,5 mm lors du balayage sur la surface dans la direction x et y et la zone d'exclusion de bordure étant de 2 mm par rapport au bord de la tranche et la largeur de pas étant de ∼10 µm lors du balayage sur la face fendue de la tranche se trouvant à la perpendiculaire de la surface dans la direction z et la demi-largeur du phonon E₂ étant déterminée par des analyses de forme de lignes de Lorentz.

2. Substrat de III-N dégagé selon la revendication 1, dans lequel la surface du matériau de III-N a été polie à l'aide d'un moyen de lissage contenant des particules abrasives sous la forme d'une dispersion en suspension à base aqueuse, dans lequel le matériau des particules abrasives utilisées de la suspension est le nitrure de bore cubique, et l'opération de polissage a inclus plusieurs étapes lors desquelles la granulométrie moyenne des particules de nitrure de bore cubique diminue à chacune des étapes suivantes.

3. Substrat de III-N dégagé selon la revendication 1 ou 2, dans lequel la surface du substrat de III-N dégagé représente un plan c, a, m ou r orienté exactement ou un plan qui présente une désorientation de 0,1 à 30° par rapport à un plan c, a, m ou r, de préférence une surface ayant un plan c polaire pour III orienté exactement ou un plan qui présente une désorientation de 0,1 à 1° par rapport à un plan c polaire pour III orienté exactement.

4. Substrat de III-N dégagé selon la revendication 2 ou 3, dans lequel les particules abrasives de nitrure de bore cubique utilisées au cours de l'opération de polissage en trois étapes successives ont présenté une granulométrie moyenne respectivement de plus de 4 à 7 µm, de 2 à moins de 4 µm et de 0,5 à moins de 2 µm, de préférence ont présenté une granulométrie moyenne respectivement d'environ 6 µm, d'environ 3 µm et d'environ 1 µm.

5. Substrat de III-N dégagé selon l'une des revendications 2 à 4, dans lequel une opération de rodage a été effectuée avant l'opération de polissage, dans laquelle le nitrure de bore cubique a été utilisé comme moyen de rodage.

6. Substrat de III-N dégagé selon l'une des revendications 2 à 5, dans lequel l'opération de polissage avec du nitrure de bore cubique comme moyen de lissage a été appliquée sur la surface [0001] du matériau de III-N polaire pour III.

7. Matrice de III-N, dans laquelle III représente au moins un élément du groupe III du système périodique choisi parmi Al, Ga et In ; la matrice comprenant un substrat étranger, une couche de III-N supérieure et le cas échéant une ou plusieurs couches intermédiaires constituées de III-N ou d'un autre matériau, la matrice de III-N possédant un diamètre supérieur à 40 mm et (i) lors d'une cartographie sur la surface par interférométrie à lumière blanche, l'écart-type des valeurs RMS étant de 5 % ou moins, et en outre :
(ii) lors d'une cartographie par courbe d'oscillation sur la surface parallèle au plan de croissance, l'écart-type des demi-largeurs mesurées étant de 5 % ou moins, et/ou
(iii) lors d'une cartographie par micro-spectrométrie Raman sur la surface parallèle au plan de croissance, l'écart-type des demi-largeurs mesurées du phonon E₂ étant de 5 % ou moins ;
dans laquelle les cartographies citées peuvent être mesurées dans les conditions suivantes :
ad (i) - cartographie de la surface de la tranche avec un interféromètre à lumière blanche : après avoir divisé la surface de la tranche en un maillage de 5 mm d'intervalle respectivement au maximum dans deux directions orthogonales l'une à l'autre, un balayage de la surface est réalisé en respectant une zone d'exclusion de bordure de 5 mm dans chaque maillage, la zone de balayage étant au moins de 1 % de la taille du maillage et les valeurs RMS étant mesurée par un interféromètre à lumière blanche en utilisant de la lumière blanche ;
ad (ii) - cartographie par courbe d'oscillation : des courbes de diffraction aux rayons X sont établies conformément à la diffraction sur des ciseaux de plan de réseau déterminés, les balayages ω étant enregistrés à différents endroits de test de la surface dans un plan parallèle au plan de croissance, après quoi l'écart-type des moyennes des demi-largeurs des balayages ω enregistrés est déterminé ;
ad (iii) - mesures par micro-spectrométrie de Raman pour déterminer la demi-largeur de E₂ :
- longueur d'onde d'excitation du laser de 532 nm (Laser Nd:YAG doublé en fréquence),
- puissance d'excitation de 3 mW
- focalisation de la ligne laser à l'aide d'une optique de microscope sur un diamètre de faisceau de ∼1 µm sur l'échantillon,
le spectromètre étant calibré à l'aide de lignes de plasma Ne, la mesure étant réalisée en géométrie de rétrodiffusion, la largeur de pas étant de ∼2,5 mm lors du balayage sur la surface dans la direction x et y et la zone d'exclusion de bordure étant de 2 mm par rapport au bord de la tranche et la largeur de pas étant de ∼10 µm lors du balayage sur la face fendue de la tranche se trouvant à la perpendiculaire de la surface dans la direction z et la demi-largeur du phonon E₂ étant déterminée par des analyses de forme de lignes de Lorentz.

8. Matrice de III-N selon la revendication 7, dans laquelle la surface du matériau de III-N a été polie à l'aide d'un moyen de lissage contenant des particules abrasives sous la forme d'une dispersion en suspension à base aqueuse, dans laquelle le matériau des particules abrasives utilisées de la suspension est le nitrure de bore cubique, et l'opération de polissage a inclus plusieurs étapes lors desquelles la granulométrie moyenne des particules de nitrure de bore cubique diminue à chacune des étapes suivantes.

9. Matrice de III-N selon la revendication 7 ou 8, dans laquelle la surface du substrat de III-N dégagé représente un plan c, a, m ou r orienté exactement ou un plan qui présente une désorientation de 0,1 à 30° par rapport à un plan c, a, m ou r, de préférence une surface ayant un plan c polaire pour III orienté exactement ou un plan qui présente une désorientation de 0,1 à 1° par rapport à un plan c polaire pour III orienté exactement.

10. Matrice de III-N selon la revendication 8 ou 9, dans laquelle les particules abrasives de nitrure de bore cubique utilisées au cours de l'opération de polissage en trois étapes successives ont présenté une granulométrie moyenne respectivement de plus de 4 à 7 µm, de 2 à moins de 4 µm et de 0,5 à moins de 2 µm, de préférence ont présenté une granulométrie moyenne respectivement d'environ 6 µm, d'environ 3 µm et d'environ 1 µm.

11. Matrice de III-N selon l'une des revendications 8 à 10, dans laquelle une opération de rodage a été effectuée avant l'opération de polissage, dans laquelle le nitrure de bore cubique a été utilisé comme moyen de rodage.

12. Matrice de III-N selon l'une des revendications 8 à 11, dans laquelle l'opération de polissage avec du nitrure de bore cubique comme moyen de lissage a été appliquée sur la surface [0001] du matériau de III-N polaire pour III.

13. Matrice de III-N selon l'une des revendications 7 à 12, dans laquelle le matériau du substrat étranger est choisi dans le groupe constitué du saphir, du carbure de silicium, du nitrure de gallium, du nitrure d'aluminium, de l'arséniure de gallium, de l'oxyde de zinc, du silicium, de l'aluminate de lithium et du gallate de lithium.

14. Utilisation du substrat de III-N selon l'une des revendications 1 à 6 ou d'une matrice de III-N selon l'une des revendications 7 à 13 pour la fabrication d'un composant optique, électronique ou opto-électronique.
